# EUROPEAN PATENT APPLICATION

(11) **EP 2 837 899 A1**
(43) Date of publication of application: **18.02.2015**
(21) Application number: 13781235.0
(22) Date of filing: 25.03.2013
(51) Int. Cl.: F24J 2/38, H01L 31/042, F24J 2/54

(54) **TRACKING DEVICE FOR SOLAR POWER GENERATION**

(30) Priority: 26.04.2012 KR 20120044164
(71) Applicant: Lee, Seong Ju, Chungcheongnam-do 336-834 (KR); Goryeo Green Mix Co. Ltd., Chungcheongnam-do 336-821 (KR)
(72) Inventor: LEE, Seong Ju, Chungcheongnam-do 336-834 (KR)
(74) Representative: Hocking, Adrian Niall
(86) International application number: PCT/KR2013/002448
(87) International publication number: WO 2013/162179

(57) **Abstract**

The present invention relates to a tracking device for solar power generation. Multiple wires and rollers are used to minimize the number of motors while adjusting the inclination of multiple solar cell arrays, and thus installation and maintenance costs can be reduced and safety can be ensured by reducing external pressure exerted e.g. by the wind.

## Description

### Technical Field

The solar cell serves to receive the sunlight and convert it into an electrical energy and the solar cell module is produced by the panel having a plurality of solar cells connected to each other so as to increase the voltage. Also, it is called as an Array in that the solar cell modules are combined with each other so as to obtain a practical power generation output. Moreover, it is called as a solar photovoltaic system (PV system) in that inverters, cables and so on are combined so as to put the Array to practical use.

Since the output efficiency of the solar cell is changed by the irradiation, it requires various driving devices so as to control the array direction on the altitude and azimuth of the sun in such a manner that it vertically corresponds to the angle of incidence of sunlight in accordance with the change of the solar orbit. Also, it is called as a solar tracking device.

The present invention relates to a tracking device for solar power generation, and more particularly, to a tracking device for solar power generation in that multiple wires and rollers are used to minimize the number of motors while adjusting the inclination of multiple solar cell arrays, and thus installation and maintenance costs can be reduced and safety can be ensured by reducing external pressure exerted by the wind etc.

### Background Art

Since the power conversion efficiency is greatly influenced by the intensity of radiation irradiated to the surface of a solar cell, above all, the optimum direction and the installation angle towards the sun act as an important facto.

The solar photovoltaic system takes a variety of forms in order to adjust the angle of an incidence of the solar light. Generally, it is divided into a fixing type, a single axis driving type, and a dual axes driving type.

The fixing type is designed to have a fixed incident plane set at an angle of approximately 30 degrees depending on the solar altitude toward south in Korea.

The single axis driving type is designed to track any one of the solar altitude and the azimuth according to the sun trajectory by rotating the solar photovoltaic system around a single rotation axis.

The dual axes driving type is designed to track a more accurate sun by corresponding to the altitude and azimuth of the sun so as to increase the maximum solar radiation, thereby maximizing the power generating efficiency.

In general, the large-scale solar power station is applicable to the dual axes driving system of requiring a high generation efficiency. Also, it installs an automatic driving system for increasing the accuracy during the tracking of the sunlight by using the program using the formula of the solar position and the sensor of sensing the light.

As an example configuration of a tracking device for improving the condensing efficiency, the "solar cell module having a solar tracking device" (Korea Patent Registration No. 10-0656139, Patent Document 1) is disclosed.

In the technology as described above, it is configured to provide two rotation devices and control each rotation device by the control unit.

However, in the conventional art, since two rotation devices are installed on every module, there is a problem in that it has the installation and maintenance costs a lot.

In order to solve these problems, it discloses the technology, "Solar tracking device using suspension mechanism" (Korea Patent Registration No. 10-0780571, Patent Document 2) including a main support rod vertically and horizontally rotated to the back of the solar photovoltaic condensing panel for condensing the sunlight, a suspension device for vertically and horizontally rotating the solar photovoltaic condensing panel on the main support rod, a driving motor controlled by a solar sensor and a electronic controller and formed at the suspension, horizontal and vertical support members rotated to the main support rod, and elastic connecting members elastically moved to both front ends of the horizontal and vertical support members up and down, thereby the structure thereof is simple and the installation thereof is easy.

However, since the Patent Document 2 is also provided with two motors in one solar photovoltaic condensing module, the number of the requiring motor is increased in proportion to that of the solar photovoltaic system in a large-scale solar power station in that a plurality of solar cell panels is formed in multiple rows. Accordingly, there is a problem in that it has the installation and maintenance costs a lot.

That is, it is necessary to develop an inexpensive tracking device for solar power generation in terms of the installation and maintenance costs.

### PRIOR ART DOCUMENT

Patent Document 1 Korean Patent Registration No. 10-0656139(December 05 15, 2006)
Patent Document 1 Korean Patent Registration No. 10-0780571(November 23 15, 2007)

### Disclosure

### Technical Problem

Accordingly, the present invention has been made to solve the above-mentioned problems occurring in the prior art, and a object of the present invention is to provide a tracking device for solar power generation in that an angle of a plurality of solar cell panels can be adjusted by using only a minimum motor, so that installation and maintenance costs thereof can be reduced.

More specifically, a second wire is connected to both ends of each solar cell panel, a first wire is connected to the second wire formed at each solar cell panel, and a driving device for pulling and moving the first wire is provided, so that the second wire is selectively pulled according to the operation of the driving device, thereby controlling the angle of the solar cell panel according to the operation of the driving device and minimizing the number of the motor.

In addition, a plurality of support rollers is formed at a lower portion of the solar cell panel and a driving device is formed at a row of one side thereof, so that the angle adjustment of the solar cell panel can be easily performed through a relatively simple component.

In particular, where the left and right sides of the solar cell panel is vertically rotated and the second wire formed at the left end thereof is pulled, the second wire formed at the right end thereof and opposed thereto is released, thereby preventing the solar cell panel from being shook due to the effects of the wind and so on and minimize number of the driving device.

### Technical solution

In order to accomplish this object, there is provided a tracking device for solar power generation for slantly rotating solar cell panels according to the position of the sun in photovoltaic generating facilities having the plurality of the solar cell panels arranged in multiple rows and pillar connected to a bottom of each solar cell panel so as to rotate left and right sides of the solar cell panels in the vertical direction including: a driving device adjacently installed to any one row of the plurality of the solar cell panels arranged in multiple rows and including a winding member having a forward moving part parallel to the row direction thereof and a reversely moving part moved in the opposite direction of the forward moving part, the forward moving portion and the reversely moving part being configured to be movable in both directions; a first support roller separated from both lower circumference sides of the pillar; a second support roller closely installed to the forward moving part of the driving device; a third support roller closely installed to the reversely moving part of the driving device; a first wire having one side connected to the forward moving part of the driving device, a middle portion of one side thereof for wrapping the second support roller, the other side connected to the reversely moving part of the driving device, and a middle portion of the other side thereof for wrapping the third support roller and configured to move forward and backward according to the forward and backward movement of the winding member; and two second wires having one side connected to ends of both sides of the solar cell panel respectively, a middle portion configured to wrap the first support roller, which is located at the lower portion of the solar cell panel, and the other side connected to the first wire, so that the solar cell panel can be rotated by pulling one side of the solar cell panel according to the driving of the first wire.

At this time, the driving device includes two rotation axes rotatably formed on both ends of any one row of the plurality of the solar cell panels arranged in multiple rows respectively, a winding member for wrapping two rotation axes having the forward moving part moved to one side thereof and the reversely moving part moved in the opposite direction of the forward moving part, and a driving motor for rotating the rotation axes in both directions connected to any one of two rotation axes.

Also, the first wire and the second wire are any one of a rope having a circular cross-section, a steel wire, and a chain.

Also, separation prevention prominences are formed at the circumference of both ends of the first support roller, the second support roller, and the third support roller and boundary prominences are formed at the circumference of the center thereof.

At this time, a first inclined portion is formed at the wall surface of one side of the boundary prominence and a second inclined portion is formed at the wall surface of the separation prevention prominences opposed to first inclined portion and is formed in parallel to the first inclined portion.

### Advantageous Effects

According to the present invention, the angle of the plurality of the solar cell panels can be adjusted by using only a minimum motor, so that the installation and maintenance costs can be reduced.

More specifically, the second wire is connected to both ends of each solar cell panel, the first wire is connected to the second wire formed at each solar cell panel, and the driving device for pulling and moving the first wire is provided, so that the second wire is selectively pulled according to the operation of the driving device, thereby controlling the angle of the solar cell panel according to the operation of the driving device and minimizing the number of the motor.

In addition, the plurality of the support rollers is formed at the lower portion of the solar cell panel and the driving device is formed at a row of one side thereof, so that the angle adjustment of the solar cell panel can be easily performed through a relatively simple component.

In particular, where the left and right sides of the solar cell panel is vertically rotated and the second wire formed at the left end thereof is pulled, the second wire formed at the right end thereof and opposed thereto is released, thereby preventing the solar cell panel from being shook due to the effects of the wind and so on and minimize number of the driving device.

### Brief Description of the Drawings

The above and other objects, features and advantages of the present invention will be more apparent from the following detailed description taken in conjunction with the accompanying drawings, in which:
FIG. 1 is a perspective view illustrating one embodiment of a tracking device for a solar power generation of the present invention;

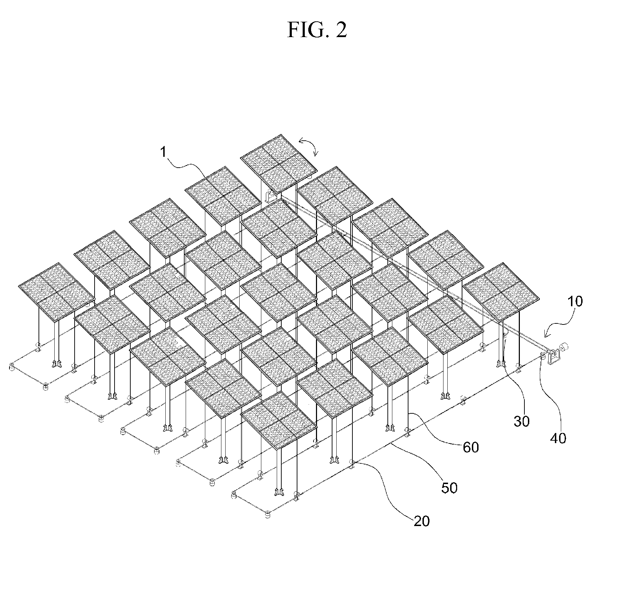

FIG. 2 is a perspective view illustrating a state of installing a tracking device for a solar power generation of the present invention in a state that of a plurality of condensing panels is installed therein;
FIG. 3 is a schematically planar view illustrating an installation state of a tracking device for a solar power generation of the present invention;
FIG. 4 is a schematically planar view illustrating a state of installing a tracking device for a solar power generation of the present invention in a state that a first wire is integrally formed therein;
FIG. 5 is a perspective view illustrating an embodiment of support rollers in a tracking device for a solar power generation of the present invention;

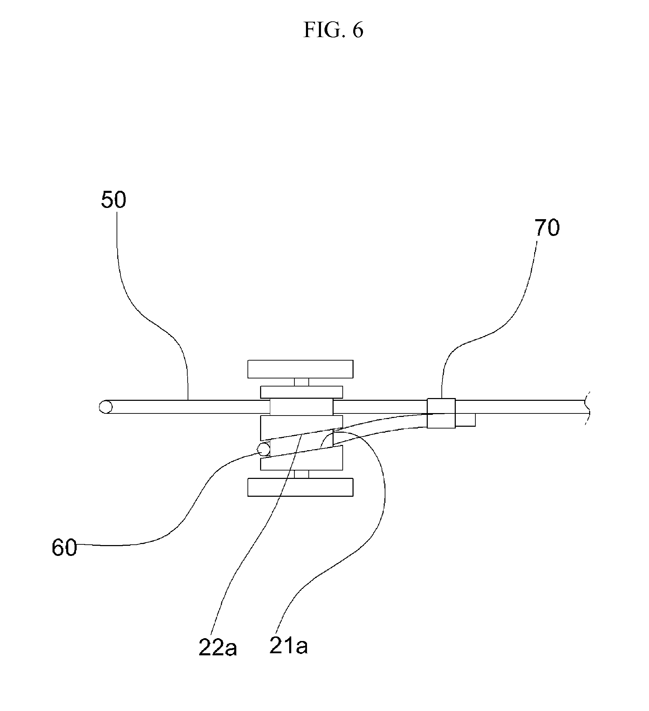

FIG. 6 is a perspective view illustrating an example that is configured to guide wires through support rollers in a tracking device for a solar power generation of the present invention; and
FIG. 7 is a perspective view illustrating another embodiment of a tracking device for a solar power generation of the present invention.

### <Descriptions on reference numbers for the major components in the drawings>

1: solar cell panel
2: pillar
10: driving device
11: rotation axis
12: winding member
12a: forward moving part
12b: reversely moving part
13: driving motor
20: first support roller
21: separation prevention prominence
21a: second inclined portion
22: boundary prominence
22a: first inclined portion
30: second support roller
40: third supporting roller
50: first wire
60: second wire
70: fastener
80: pivot support roller

### Best Mode

### Mode for Invention

Hereinafter, an exemplary embodiment of the present invention will be described in detail with reference to the accompanying drawings. The known functions and configurations will be omitted for the description that may unnecessarily obscure the gist of the invention in detail.

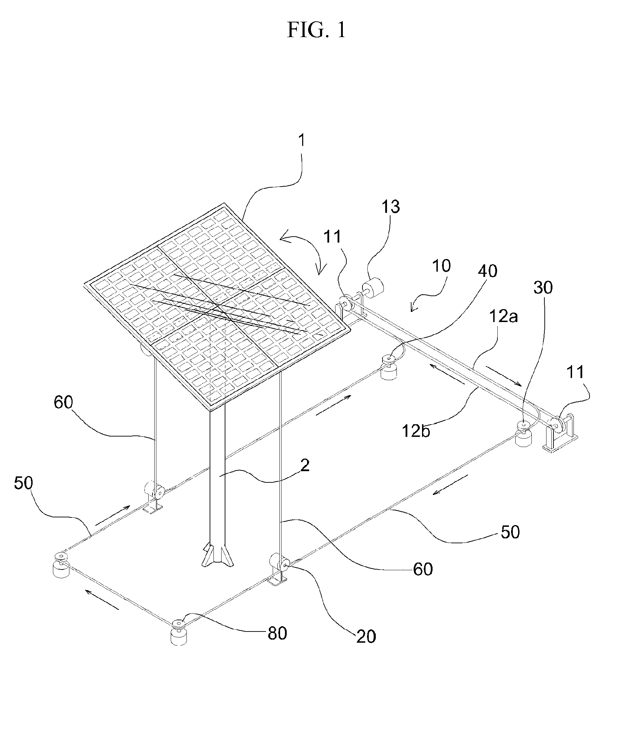

As shown in FIG. 1, a tracking device for a solar power generation according to the present invention includes a plurality of solar cell panels arranged in multiple rows and pillar 2 connected to a bottom of each solar cell panel 1.

At this time, the left and right sides of the solar cell panel 1 is connected to be rotatable in the vertical direction.

The tracking device for the solar power generation of the present invention serves to slantly rotate the solar cell panel 1 according to the position of the sun in the photovoltaic generating facilities.

The tracking device for the solar power generation of the present invention largely includes a driving device 10, a first support roller 20, a second support roller 30, a third support roller 40, a first wire 50 and a second wire 60.

The driving device 10 is adjacently installed to any one row of the plurality of the solar cell panels 1 arranged in multiple rows and includes a forward moving part 12a parallel to the row direction thereof and a reversely moving part 12b moved in the opposite direction of the forward moving part 12a.

In addition, the forward moving portion 12a and the reversely moving part 12b are configured to be movable in both directions.

This driving device 10 may be applied in a variety of known devices such as a belt conveyor or a chain conveyor etc.

As shown, the specific structure of the driving device 10 includes two rotation axes 11 rotatably formed on both ends thereof, a winding member 12 for wrapping two rotation axes 11, and a driving motor 13 for rotating the rotation axes 11 in both directions connected to any one of two rotation axes 11.

Accordingly, the winding member 12 includes the forward moving part 12a moved to one side thereof according to the rotation of the driving motor 13 and the reversely moving part 12b moved in the opposite direction of the forward moving part 12a.

At this time, the direction of the forward moving part 12a and the reversely moving part 12b of the driving device 10 may be parallel to the direction of the rotated solar cell panel 1 or perpendicularly to the direction of the rotated solar cell panel 1.

In the meantime, the first support rollers 20 are separated from both lower circumference sides of the pillar 2. It is preferred that the first support rollers 20 are formed at the lower portions of left and right ends of the solar cell panel 1.

As shown, the second support roller 30 is closely installed to the forward moving part 12a of the driving device 10 and the third support roller 40 is closely installed to the reversely moving part 12b of the driving device 10.

One side of the first wire 50 is connected to the forward moving part 12a of the driving device 10.

Also, in a state that the end of one side of the first wire 50 is connected and fixed to the forward moving part 12a of the driving device 10, the middle portion of the first wire 50 wraps the second support roller 30.

Moreover, the other side of the first wire 50 of the driving device 10 is connected and fixed to the reversely moving part 12b and the middle portion of the other side of the first wire 50 wraps the third support roller 40.

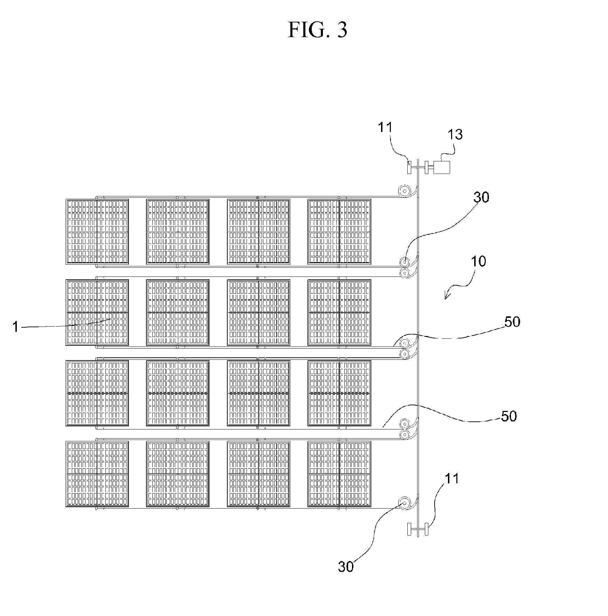

In this case, as shown in FIG. 3, in the first wire 50, one part thereof connected to the forward moving part 12a of the driving device 10 and the other part thereof connected to the reversely moving part 12b of the driving device 10 are separated from each other and each end is connected to the second wires 60 connected to the solar cell panel 1, which is furthest away from the driving device 10.

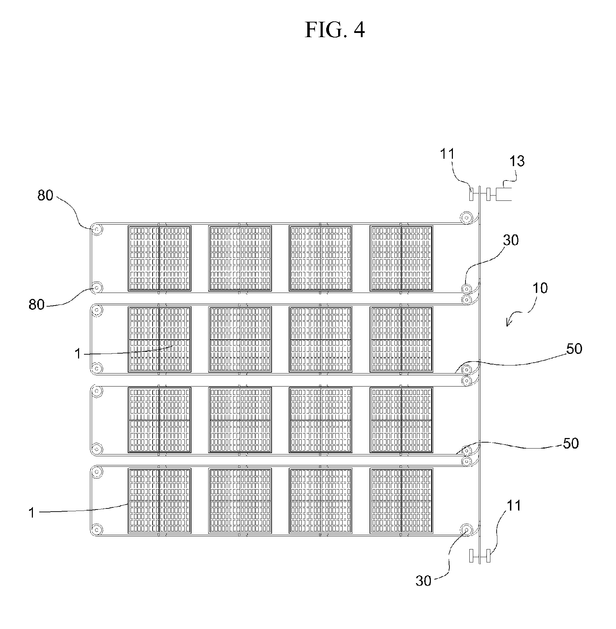

Or, as shown in FIG. 4, in the first wire 50, one part thereof connected to the forward moving part 12a of the driving device 10 and the other part thereof connected to the reversely moving part 12b of the driving device 10 are integrally connected to each other and the middle portion thereof passes through the solar cell panel 1, which is furthest away from the driving device 10. At this time, a pivot support roller 80 is formed at the outskirts of the solar cell panel 1, so that the first wire 50 can surround the pivot support roller 80.

By the configuration of the first wire 50 as described above, the moving direction of the forward moving part 12a and the reversely moving part 12b changes from forward and backward to backward and forward according to the rotational direction of the driving motor 13 installed in the driving device 10.

In the meantime, as shown, two second wires 60 include one side connected to ends of both sides of the solar cell panel 1 respectively, middle portion configured to wrap the first support roller 20, which is located at the lower portion of the solar cell panel 1, and the other side connected and fixed to the first wire 50, so that the solar cell panel 1 can be rotated about the pillar 2 by pulling one side of the solar cell panel 1 according to the driving of the first wire 50.

At this time, if the second wire 60 connected to the front end of the solar cell panel 1 is pulled, the other second wire 60 connected to the rear end of the solar cell panel 1 is released. That is, any one of two second wires 60, which are opposite to each other, is connected to the first wire 50, which is connected to the forward moving portion 12a of the winding member 12 of the driving device 10 and the other second wire 60 is connected to the first wire 50, which is connected to the reversely moving part 12b of the winding member 12 of the driving device 10

Accordingly, where one side thereof is pulled, it can prevent the other side thereof from being loosen optionally. Therefore, it can prevent the solar cell panel 1 from damaged by hitting the surface of the adjacent solar cell panel 1 owing to the unwinding of any one of the second wires 60 affected by the wind and so on, thereby ensuring stability thereof.

According to the configuration as described above, the second support roller 30 and the third support roller 40 are in contact with the forward moving portion 12a and the reversely moving part 12b, thereby guide the moving of the winding member 12.

At this time, the first wire 50 and the second wire 60 are connected to each other and the first wire 50 and the winding member 12 are connected to each other. Since this connection relationship is made between X, Y, and Z axes, it is preferred that the first wire 50 and the second wire 60 may be any one of a rope having a circular cross-section, a steel wire, and a chain.

At this time, where the first wire 50 and the second wire 60 have a cylindrical section, if the first support roller 20, the second support roller 30, and the third support roller 40 serve as the guide thereof, the wires can be overlapped when the first wire 50 and the second wire 60 is wound on the first support roller 20, the second support roller 30, and the third support roller 40. In this case, the push and pull operations are not smooth in the winding process thereof.

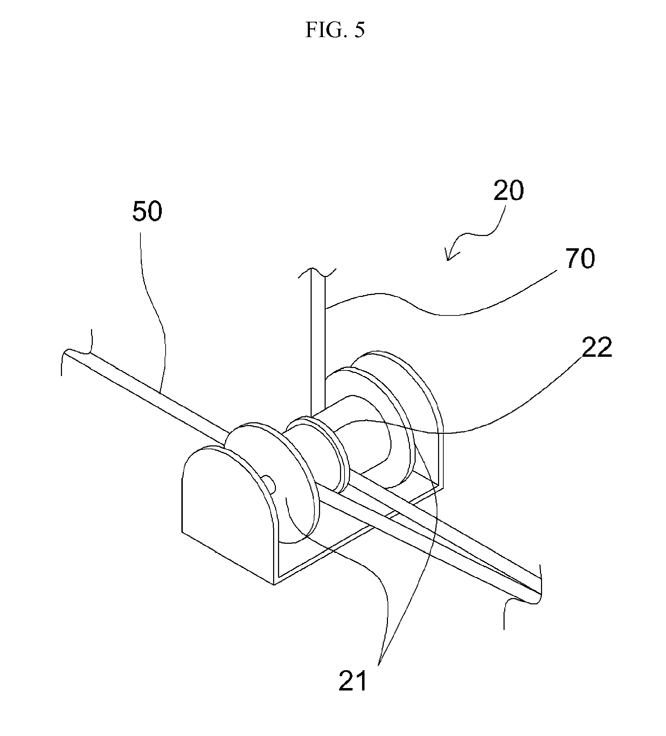

In order to this phenomenon, as shown in FIG. 5, separation prevention prominences 21 are formed at the circumference of both ends of the first support roller 20, the second support roller 30, and the third support roller 40 and boundary prominences 22 are formed at the circumference of the center thereof, so that the guided wire and the wound wire are separated from each other through the boundary prominence 22 to be passed therethrough.

At this time, since the end of the wound wire and the end of the guided wire are connected and fixed to each other through fastener 70 such as a clamp shown in FIG, 6, a first inclined portion 22a is formed at the wall surface of one side of the boundary prominence 22 and a second inclined portion 21a is formed at the wall surface of the separation prevention prominences 21 opposed to first inclined portion 22a and is formed in parallel to the first inclined portion 22a, so that the end of the wound wire can be smoothly fixed to the guided wire to be passed therethrough.

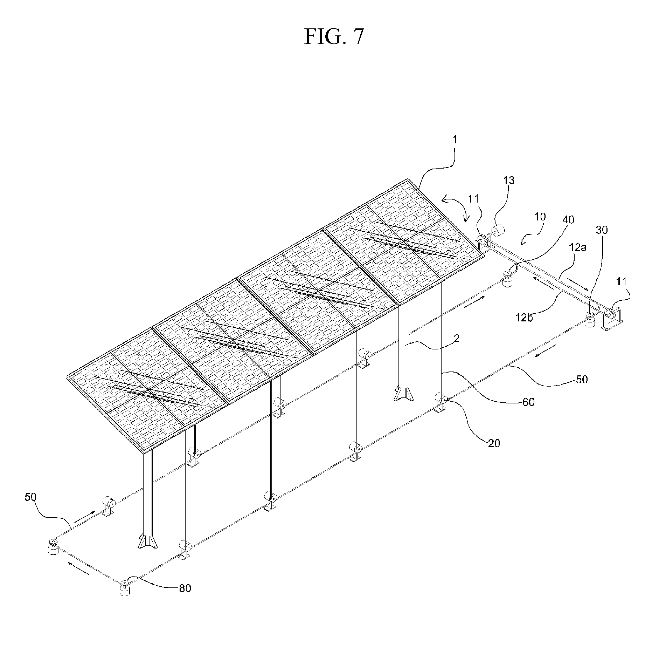

In addition, FIG. 7 illustrates another embodiment of the present invention.

As shown in FIG. 7, where the plurality of the solar cell panels 1 is formed in a line, the pillars 2 are not formed at each solar cell panel 1. That is, optionally, the pillars 2 can be formed at a small number of solar cell panels 1.

In this case, as shown, the second wires 60 can be connected to each solar cell panel 1 to be driven. Although it is not shown, where the plurality of the solar cell panels 1 is formed in a line, each solar cell panel 1 can be connected to each other to be rotated together. Also, selectively, the second wire 60 is configured to form at only a few solar cell panels 1.

Although a preferred embodiment of the present invention has been described for illustrative purposes, those skilled in the art will appreciate that various modifications, additions and substitutions are possible, without departing from the scope and spirit of the present invention as disclosed in the accompanying claims.

### Industrial Applicability

The tracking device for solar power generation can be installed in and applied to large-scale power generation facilities, medium-scale power generation facilities such agricultural industrial complex etc., or small facilities installed additionally in various buildings.

## Claims

1. A tracking device for solar power generation for slantly rotating solar cell panels 1 according to the position of the sun in photovoltaic generating facilities having the plurality of the solar cell panels 1 arranged in multiple rows and pillar connected to a bottom of each solar cell panel 1 so as to rotate left and right sides of the solar cell panels 1 in the vertical direction comprising:
a driving device 10 adjacently installed to any one row of the plurality of the solar cell panels 1 arranged in multiple rows and comprising a winding member 12 having a forward moving part 12a parallel to the row direction thereof and a reversely moving part 12b moved in the opposite direction of the forward moving part 12a, the forward moving portion 12a and the reversely moving part 12b being configured to be movable in both directions;
a first support roller 20 separated from both lower circumference sides of the pillar 2;
a second support roller 30 closely installed to the forward moving part 12a of the driving device;
a third support roller 40 closely installed to the reversely moving part 12b of the driving device 10;
a first wire 50 having one side connected to the forward moving part 12a of the driving device 10, a middle portion of one side thereof for wrapping the second support roller 30, the other side connected to the reversely moving part 12b of the driving device 10, and a middle portion of the other side thereof for wrapping the third support roller 40 and configured to move forward and backward according to the forward and backward movement of the winding member 12; and
two second wires 60 having one side connected to ends of both sides of the solar cell panel 1 respectively, a middle portion configured to wrap the first support roller 20, which is located at the lower portion of the solar cell panel 1, and the other side connected to the first wire 50, so that the solar cell panel 1 can be rotated by pulling one side of the solar cell panel 1 according to the driving of the first wire 50.

2. A tracking device for solar power generation for slantly rotating solar cell panels 1 according to the position of the sun in photovoltaic generating facilities having the plurality of the solar cell panels 1 arranged in multiple rows and pillar connected to a bottom of each solar cell panel 1 so as to rotate left and right sides of the solar cell panels 1 in the vertical direction comprising:
a driving device 10 adjacently installed to any one row of the plurality of the solar cell panels 1 arranged in multiple rows and having two rotation axes 11 rotatably formed on both ends thereof, a winding member 12 for wrapping two rotation axes 11, and a driving motor 13 for rotating the rotation axes 11 in both directions connected to any one of two rotation axes 11, the winding member 12 having a forward moving part 12a moved to one side thereof and a reversely moving part 12b moved in the opposite direction of the forward moving part 12a according to the rotation of the driving motor 13;
a first support roller 20 separated from both lower circumference sides of the pillar 2;
a second support roller 30 closely installed to the forward moving part 12a of the driving device;
a third support roller 40 closely installed to the reversely moving part 12b of the driving device 10;
a first wire 50 having one side connected to the forward moving part 12a of the driving device 10, a middle portion of one side thereof for wrapping the second support roller 30, the other side connected to the reversely moving part 12b of the driving device 10, and a middle portion of the other side thereof for wrapping the third support roller 40 and configured to move forward and backward according to the forward and backward movement of the winding member 12; and
two second wires 60 having one side connected to ends of both sides of the solar cell panel 1 respectively, a middle portion configured to wrap the first support roller 20, which is located at the lower portion of the solar cell panel 1, and the other side connected to the first wire 50, so that the solar cell panel 1 can be rotated by pulling one side of the solar cell panel 1 according to the driving of the first wire 50.

3. A tracking device for solar power generation as claimed in claims 1 or 2, wherein the first wire 50 and the second wire 60 are any one of a rope having a circular cross-section, a steel wire, and a chain.

4. A tracking device for solar power generation as claimed in claim 3, wherein separation prevention prominences 21 are formed at the circumference of both ends of the first support roller 20, the second support roller 30, and the third support roller 40 and boundary prominences 22 are formed at the circumference of the center thereof.

5. A tracking device for solar power generation as claimed in claim 4, wherein a first inclined portion 22a is formed at the wall surface of one side of the boundary prominence 22 and a second inclined portion 21a is formed at the wall surface of the separation prevention prominences 21 opposed to first inclined portion 22a and is formed in parallel to the first inclined portion 22a.
